# EUROPEAN PATENT APPLICATION

(11) **EP 4 040 930 A1**
(43) Date of publication of application: **10.08.2022**
(21) Application number: 19947999.9
(22) Date of filing: 04.10.2019
(51) Int. Cl.: H05K 7/20, G06F 1/20

(54) **ELECTRONIC APPARATUS**

(71) Applicant: MITSUBISHI ELECTRIC CORPORATION, Chiyoda-ku Tokyo 100-8310 (JP)
(72) Inventor: KATOU, Daisuke, Tokyo 100-8310 (JP); TAKAHASHI, Keisuke, Tokyo 100-8310 (JP); OKINISHI, Yoshio, Tokyo 100-8310 (JP); NAKANO, Hiroyuki, Tokyo 102-0073 (JP)
(74) Representative: Plasseraud IP
(86) International application number: PCT/JP2019/039306
(87) International publication number: WO 2021/064986

(57) **Abstract**

An electronic apparatus includes: a board accommodating portion (17) that accommodates a board (20) in a horizontally placed state, the board accommodating portion (17) provided inside a housing (10); an intake opening (13a) provided in a right side plate (13) of the housing (10) and communicating with the board accommodating portion (17); an exhaust opening (15a to 15d) provided in a rear plate (15) of the housing (10); a cooling fan (31 to 34) provided in such a way as to face the exhaust opening (15a to 15d); and a backboard (16) that is a partition between the board accommodating portion (17) and a fan accommodating portion (18) that accommodates the cooling fan (31 to 34), in which a left side portion and a right side portion of the backboard (16) have a left side vent (16a) and a right side vent (16b) through which the board accommodating portion (17) and the fan accommodating portion (18) communicate with each other.

## Description

### TECHNICAL FIELD

The present invention relates to an electronic apparatus having a cooling structure for cooling a board.

### BACKGROUND ART

Generally, electronic apparatuses have a cooling structure for cooling heat-generating components mounted on a board. Such cooling structures of electronic apparatuses often employ forced cooling by a cooling fan, which is disclosed in, for example, Patent Literature 1.

### CITATION LIST

### PATENT LITERATURES

Patent Literature 1: JP 2013-162014 A

### SUMMARY OF INVENTION

### TECHNICAL PROBLEM

In the above conventional electronic apparatuses, a plurality of boards are housed in a housing in a vertically placed state, and an intake opening is provided in a bottom portion of the housing, and an exhaust opening is provided in an upper portion of the housing. The conventional electronic apparatuses further cause the external air taken in from the intake opening to pass through the gaps between the boards and be discharged from the exhaust opening by driving the cooling fan installed in the upper portion of the housing.

However, since the conventional electronic apparatuses include the intake opening in the bottom portion of the housing, there is a problem that the vertical length of the housing is long. Furthermore, since the conventional electronic apparatuses include a wind guiding plate in the intake opening for the purpose of improving the cooling performance, the above problem appears clearly.

The present invention has been made to solve the problem as described above, and an object of the invention is to provide an electronic apparatus capable of cooling a heat-generating component mounted on a board without including an intake opening in a bottom portion of a housing.

### SOLUTION TO PROBLEM

An electronic apparatus according to the present invention includes: a board accommodating portion that accommodates a board in a horizontally placed state, the board accommodating portion provided inside a housing; an intake opening provided in one of a plurality of side plates of the housing and communicating with the board accommodating portion; an exhaust opening provided in a rear plate of the housing; a cooling fan provided in such a way as to face the exhaust opening; and a backboard that is a partition between the board accommodating portion and a fan accommodating portion that accommodates the cooling fan, in which a left side portion and a right side portion of the backboard each have a vent through which the board accommodating portion and the fan accommodating portion communicate with each other.

### ADVANTAGEOUS EFFECTS OF INVENTION

According to the present invention, it is possible to cool a heat-generating component mounted on a board without including an intake opening in a bottom portion of a housing.

### BRIEF DESCRIPTION OF DRAWINGS

FIG. 1 is an overall perspective view of an electronic apparatus according to a first embodiment.
FIG. 2 is a cross-sectional arrow view taken along line A-A in FIG. 1.
FIG. 3 is a right side view of the electronic apparatus according to the first embodiment.
FIG. 4 is a left side view of the electronic apparatus according to the first embodiment.
FIG. 5 is a rear view of the electronic apparatus according to the first embodiment.
FIG. 6 is a cross-sectional arrow view taken along line B-B in FIG. 2.
FIG. 7 is a front view of a backboard.
FIG. 8 is a table for explaining the air volume and the air speed of cooling air.
FIG. 9 is an overall perspective view of an electronic apparatus according to a second embodiment.
FIG. 10 is a cross-sectional arrow view taken along line C-C in FIG. 9.
FIG. 11 is a right side view of the electronic apparatus according to the second embodiment.
FIG. 12 is a left side view of the electronic apparatus according to the second embodiment.
FIG. 13 is a rear view of the electronic apparatus according to the second embodiment.
FIG. 14 is a rear perspective view illustrating a lower structure of a fan accommodating portion.
FIG. 15 is a cross-sectional arrow view taken along line D-D in FIG. 13.
FIG. 16 is a diagram illustrating a wiring state by optical fibers.

### DESCRIPTION OF EMBODIMENTS

To describe the present invention further in detail, embodiments for carrying out the present invention will be described below with reference to the accompanying drawings.

### First Embodiment

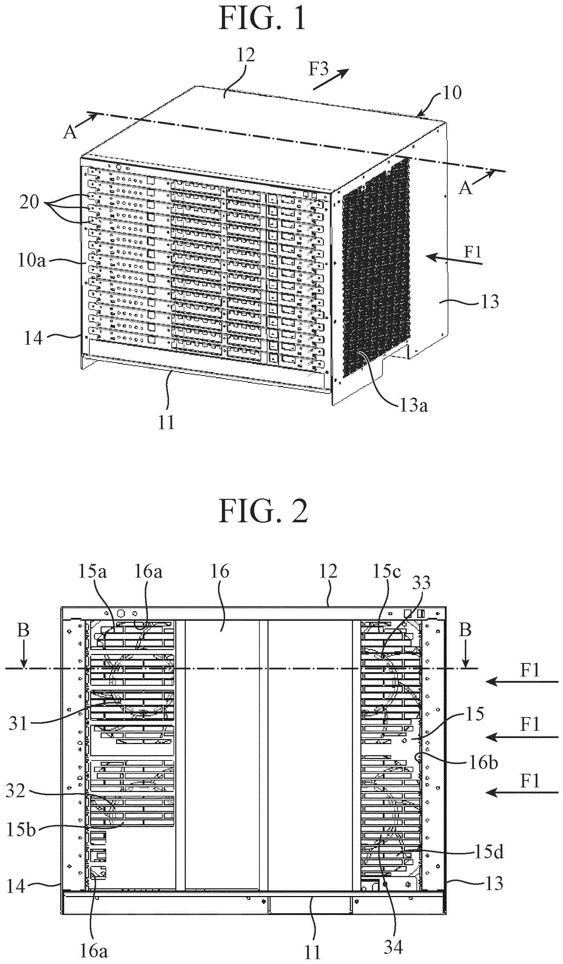

An electronic apparatus according to a first embodiment will be described with reference to FIGS. 1 to 8.

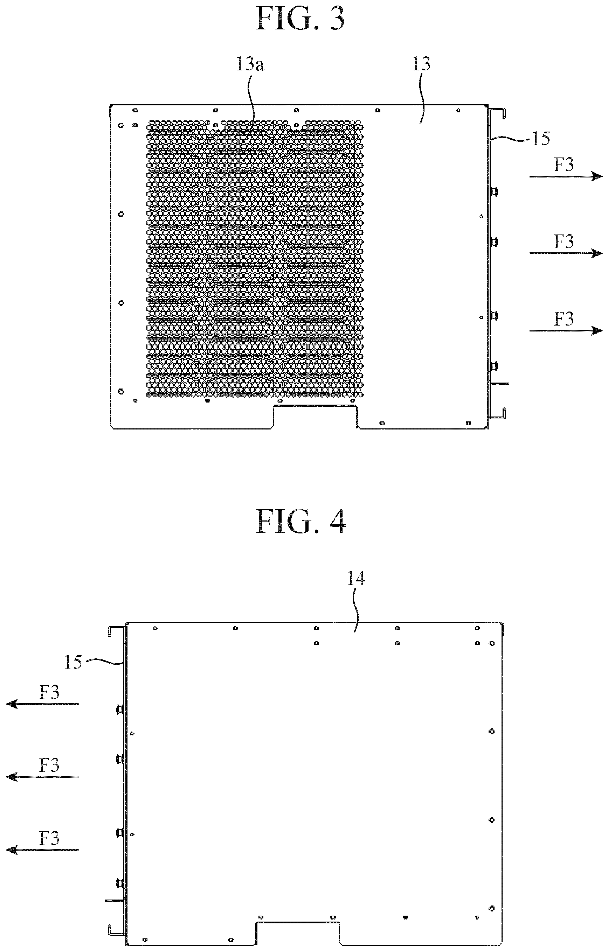

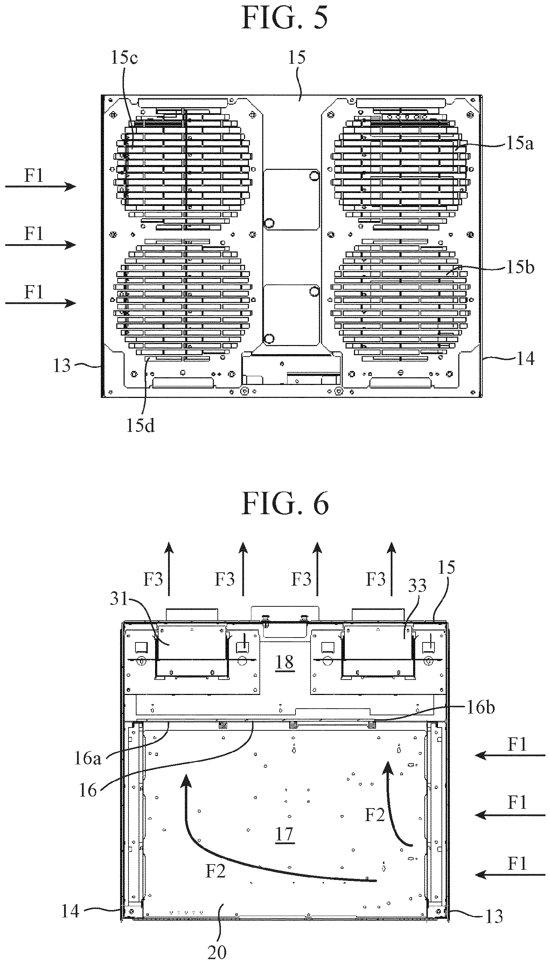

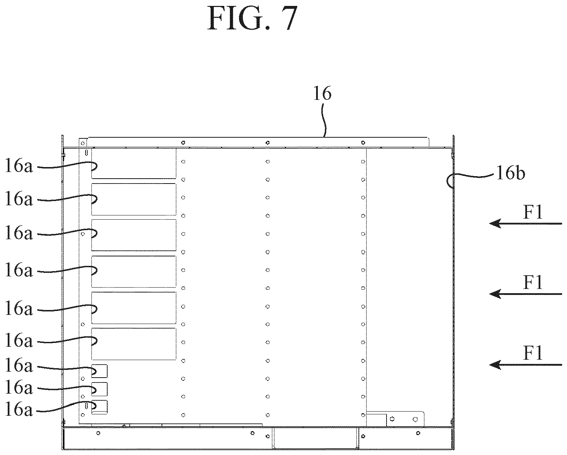

FIG. 1 is an overall perspective view of the electronic apparatus according to the first embodiment. FIG. 2 is a cross-sectional arrow view taken along line A-A in FIG. 1. FIG. 3 is a right side view of the electronic apparatus according to the first embodiment. FIG. 4 is a left side view of the electronic apparatus according to the first embodiment. FIG. 5 is a rear view of the electronic apparatus according to the first embodiment. FIG. 6 is a cross-sectional arrow view taken along line B-B in FIG. 2. FIG. 7 is a front view of a backboard 16.

As illustrated in FIGS. 1, 2, and 6, the electronic apparatus according to the first embodiment includes a housing 10 that accommodates a plurality of boards 20 and cooling fans 31 to 34 that cool the boards 20. This electronic apparatus is, for example, a communication device. The housing 10 illustrated in FIG. 1 has a structure capable of accommodating fifteen boards 20 (the lowest board 20 is hidden and thus cannot be seen). Note that the housing 10 is made of metal, for example. Note that the number of the boards 20 and the number of the cooling fans 31 to 34 are not limited thereto.

As illustrated in FIG. 1, the housing 10 accommodates the plurality of boards 20 in a horizontally placed state. Here, the horizontally placed state of the boards 20 means a state in which the boards 20 are held horizontally or substantially horizontally. As a result, the plurality of boards 20 accommodated in the housing 10 are arranged in such a way as to be parallel to each other and to overlap each other in the up-down direction. Furthermore, on the surfaces of the boards 20, heat-generating components that generate heat during operation are mounted. The cooling fans 31 to 34 are for cooling the heat-generating components mounted on the boards 20.

As illustrated in FIGS. 1 to 7, the housing 10 has a bottom plate 11, a top plate 12, a right side plate 13, a left side plate 14, a rear plate 15, and the backboard 16.

The bottom plate 11 is provided for a bottom of the housing 10. The bottom plate 11 forms the bottom of the housing 10. The top plate 12 is provided for a top of the housing 10 and faces the bottom plate 11 in the up-down direction. The top plate 12 forms a ceiling of the housing 10.

The right side plate 13 is joined to the right side end of the bottom plate 11 and the right side end of the top plate 12. The left side plate 14 is joined to the left side end of the bottom plate 11 and the left side end of the top plate 12. The rear plate 15 is joined to the bottom of the bottom plate 11, the ceiling formed by the top plate 12, the inner surface of the right side plate 13, and the inner surface of the left side plate 14.

That is, the housing 10 has a box shape with its front open and has a front opening 10a. The board 20 can be inserted into and removed from the housing 10 by passing through the front opening 10a.

The backboard 16 is provided inside the housing 10 and is provided on the front side with respect to the rear plate 15 and the cooling fans 31 to 34 in the front-rear direction of the housing 10. The backboard 16 is a partition plate that divides the internal space of the housing 10 into two in the front-rear direction. Specifically, the backboard 16 divides the internal space of the housing 10 into a board accommodating portion 17 and a fan accommodating portion 18.

The board accommodating portion 17 is a space for accommodating the plurality of boards 20. The board accommodating portion 17 is provided at the front portion of the internal space of the housing 10, and the front of the board accommodating portion 17 forms the front opening 10a.

The fan accommodating portion 18 is a space for accommodating the cooling fans 31 to 34. The fan accommodating portion 18 is provided at the rear portion of the internal space of the housing 10. The cooling fans 31 to 34 are attached to the front surface of the rear plate 15.

As illustrated in FIG. 2, the cooling fan 31 is provided at the upper left side of the fan accommodating portion 18. The cooling fan 32 is provided at the lower left side of the fan accommodating portion 18. The cooling fan 33 is provided at the upper right side of the fan accommodating portion 18. The cooling fan 34 is provided at the lower right side of the fan accommodating portion 18. Note that the installation positions of the cooling fans 31 to 34 are not limited to this and can be adjusted as appropriate.

Here, as illustrated in FIG. 3, the right side plate 13 has an intake opening 13a. The intake opening 13a allows the outside of the right side plate 13 and the inside of the board accommodating portion 17 to communicate with each other. In the example of FIG. 3, the intake opening 13a is a collection of a plurality of holes formed by punching holes; however, no limitation thereto is intended, and the quantity, shape, and size of the intake opening 13a can be adjusted as appropriate. On the other hand, as illustrated in FIG. 4, the left side plate 14 does not have any intake opening through which the outside of the left side plate 14 and the inside of the board accommodating portion 17 communicate with each other.

As illustrated in FIGS. 2 and 5, the rear plate 15 has exhaust openings 15a to 15d. The exhaust opening 15a is formed at a position facing the cooling fan 31. The exhaust opening 15b is formed at a position facing the cooling fan 32. The exhaust opening 15c is formed at a position facing the cooling fan 33. The exhaust opening 15d is formed at a position facing the cooling fan 34. In the example of FIG. 5, the exhaust openings 15a to 15d are collections of a plurality of rectangular holes; however, no limitation thereto is intended, and the quantity, shape, and size of the exhaust openings 15a to 15d can be adjusted as appropriate.

As illustrated in FIG. 7, the backboard 16 has a plurality of left side vents 16a and one right side vent 16b. The left side vents 16a and the right side vent 16b allow the board accommodating portion 17 and the fan accommodating portion 18 to communicate with each other.

The left side vents 16a are arranged in the up-down direction on the left side of the backboard 16. In the example of FIG. 7, each of the left side vents 16a is opened in a rectangular shape, and nine left side vents 16a are arranged in the up-down direction. The opening area of each of the upper six left side vents 16a is larger than the opening area of each of the lower three left side vents 16a. Note that the installation position, quantity, shape, and size of the left side vents 16a are not limited to this and can be adjusted as appropriate.

The right side vent 16b is formed on the right side of the backboard 16. In the example of FIG. 7, the right side vent 16b has a large rectangular opening on the right side of the backboard 16. Note that the installation position, quantity, shape, and size of the right side vent 16b are not limited to this and can be adjusted as appropriate.

Next, the cooling action of the electronic apparatus will be described with reference to FIG. 6.

First, when the cooling fans 31 to 34 are driven, the internal air of the board accommodating portion 17 is forcibly taken into the inside of the fan accommodating portion 18 and then is discharged to the outside of the housing 10 from the exhaust openings 15a to 15d of the rear plate 15. Along with this exhaust, outside air F1 is sucked into the inside of the board accommodating portion 17 from the intake opening 13a of the right side plate 13.

Next, the outside air F1 sucked into the inside of the board accommodating portion 17 passes through the gaps between the boards 20 adjacent to each other as cooling air F2 from the right side plate 13 side to the left side plate 14 side. As a result, the cooling air F2 flows along the surfaces of the boards 20 and thus comes into contact with the heat-generating components mounted on the surfaces thereof to take heat from the heat-generating components.

Then, the cooling air F2 turns toward the backboard 16, passes through the left side vents 16a and the right side vent 16b thereof, and thereby flows into the inside of the fan accommodating portion 18. Furthermore, the cooling air F2 that has flowed into the inside of the fan accommodating portion 18 passes through the exhaust openings 15a to 15d of the rear plate 15 and is discharged by the rotation of the cooling fans 31 to 34. As a result, when the cooling air F2 passes through the exhaust openings 15a to 15d, the cooling air F2 becomes outside air F3, and the outside air F3 releases the heat taken from the heat-generating components into the atmosphere.

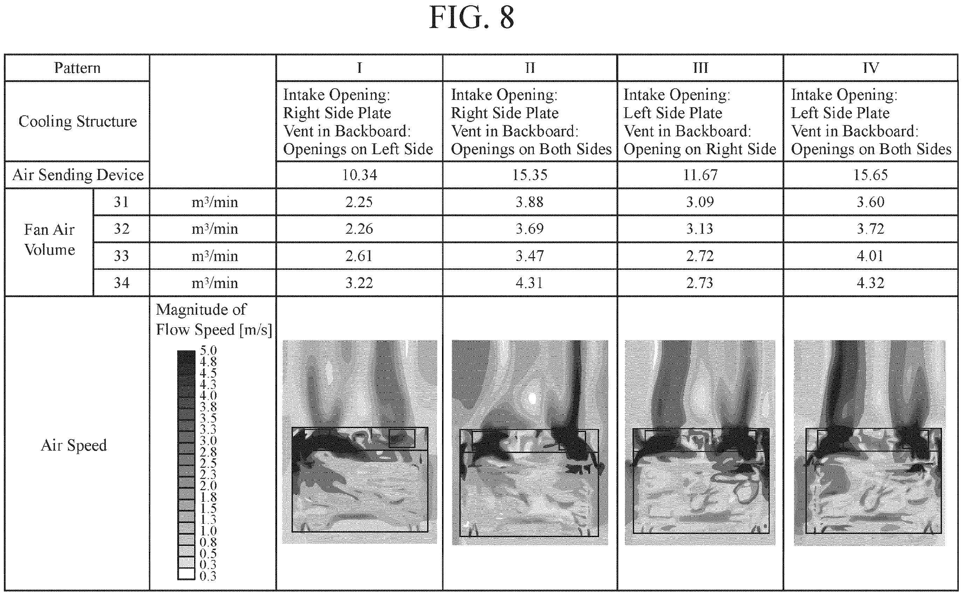

Next, the air volume and the air speed of the cooling air F2 will be described with reference to FIG. 8. FIG. 8 is a table illustrating the air volume and the air speed of the cooling air F2. In FIG. 8, the air volume and the air speed of the cooling air F2 are illustrated for each of cooling structure patterns I to IV, which include the installation position of the intake opening 13a and whether or not the left side vents 16a and the right side vent 16b are provided. Note that, in FIG. 8, the installation position of the intake opening 13a, the installation positions of the left side vents 16a and the right side vent 16b, and the installation positions of the cooling fans 31 to 34 are as described above.

In Pattern I, a cooling structure in which the intake opening 13a opens in the right side plate 13 and the backboard 16 has only the left side vents 16a is assumed. In Pattern II, a cooling structure in which the intake opening 13a opens in the right side plate 13 and the backboard 16 has both the left side vents 16a and the right side vent 16b is assumed. In Pattern III, a cooling structure in which the intake opening 13a opens in the left side plate 14 and the backboard 16 has only the right side vent 16b is assumed. In Pattern IV, a cooling structure in which the intake opening 13a opens in the left side plate 14 and the backboard 16 has both the left side vents 16a and the right side vent 16b is assumed.

The fan air volumes "31" to "34" correspond to the cooling fans 31 to 34, and the device air volume is a sum of the air volumes of the cooling fans 31 to 34. In addition, the air speed analysis diagram corresponds to FIG. 6. A longitudinally long indicator shown in a section of the air speed analysis diagram indicates the magnitude of the air speed. A dark-colored portion indicates an area where the air speed is high, and a light-colored portion indicates an area where the air speed is low.

First, Pattern I and Pattern II are compared. A commonality between Pattern I and Pattern II is the intake opening 13a which opens in the right side plate 13. As is clear from Patterns I and II, the air volume and the air speed are larger in the case where both the left side vents 16a and the right side vent 16b are provided in the backboard 16 than in the case where only the left side vents 16a are provided in the backboard 16.

Next, Pattern III and Pattern IV are then compared. A commonality between Pattern III and Pattern IV is the intake opening 13a which opens in the left side plate 14. As is clear from Patterns III and IV, the air volume and the air speed are larger in the case where both the left side vents 16a and the right side vent 16b are provided in the backboard 16 than in the case where only the right side vent 16b is provided in the backboard 16.

Furthermore, in Patterns I to IV, the air volume of each of the cooling fans 31 to 34 increases more in the cases where the left side vents 16a and the right side vent 16b in the backboard 16 are both provided than in the cases where either one of them is provided. That is, with regard to the cooling fans 31 to 34, the fan air volume of every fan is increased by providing both the left side vents 16a and the right side vent 16b in the backboard 16.

Therefore, the electronic apparatus can improve the heat dissipation performance for the boards 20 by including both the left side vents 16a and the right side vent 16b in the backboard 16.

Furthermore, the housing 10 is capable of accommodating the boards 20, which are made on the assumption that they are to be accommodated in a vertically placed state, in a horizontally placed state. Here, the vertically placed state of the boards 20 means a state in which the boards 20 are held vertically or substantially vertically. That is, the boards 20 are accommodated inside the board accommodating portion 17 in the horizontally placed state so that ends of the boards 20 are arranged near the intake opening 13a of the right side plate 13, the ends being arranged near an intake opening when the boards 20 are accommodated in the vertically placed state. As a result, the electronic apparatus can accommodate the boards 20 in the horizontally placed state in the housing 10 and thereby achieve a shorter vertical length of the housing 10 while achieving a cooling performance equivalent to that in a case where the boards 20 are accommodated in the vertically placed state.

As described the above, the electronic apparatus according to the first embodiment includes: the board accommodating portion 17 that is provided inside the housing 10 and accommodates the boards 20 in the horizontally placed state; the intake opening 13a provided in the right side plate 13 of the housing 10 and communicating with the board accommodating portion 17; the exhaust openings 15a to 15b provided in the rear plate 15 of the housing 10; the cooling fans 31 to 34 provided in such a way as to face the exhaust openings 15a to 15d; and the backboard 16 that is a partition between the board accommodating portion 17 and the fan accommodating portion 18 that accommodates the cooling fans 31 to 34. The backboard 16 has, on the left side portion and the right side portion of the backboard, the left side vents 16a and the right side vent 16b through which the board accommodating portion 17 and the fan accommodating portion 18 communicate with each other. As a result, the electronic apparatus can cool the heat-generating components mounted on the boards 20 without including an intake opening in the bottom portion of the housing 10.

### Second Embodiment

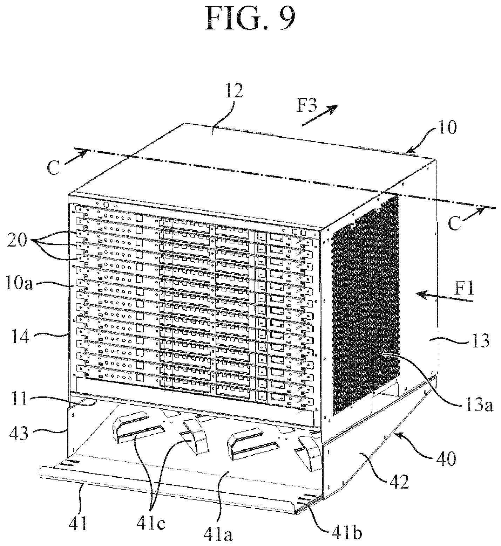

An electronic apparatus according to a second embodiment will be described with reference to FIGS. 9 to 16.

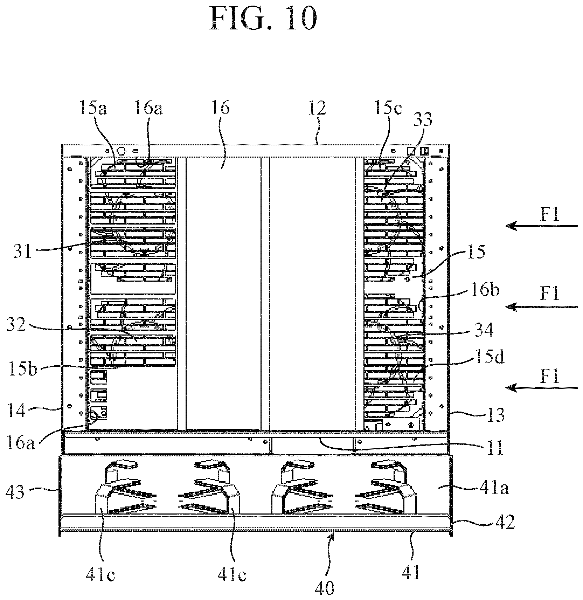

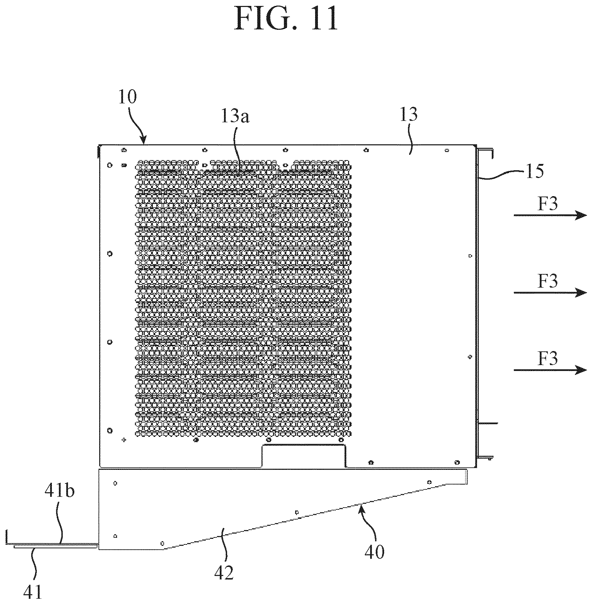

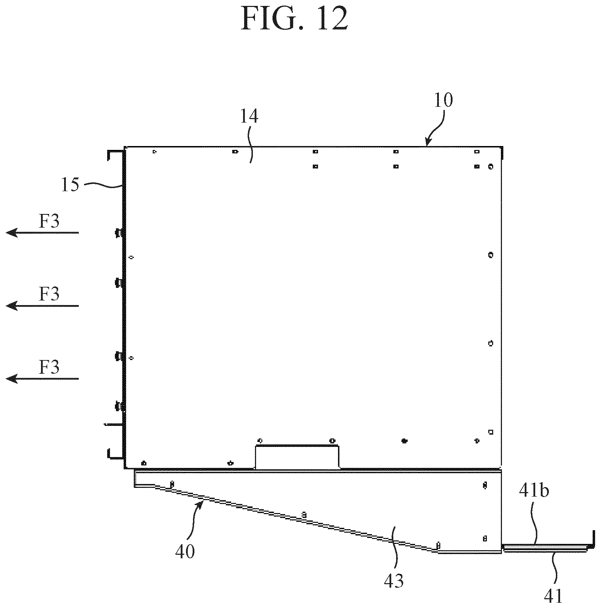

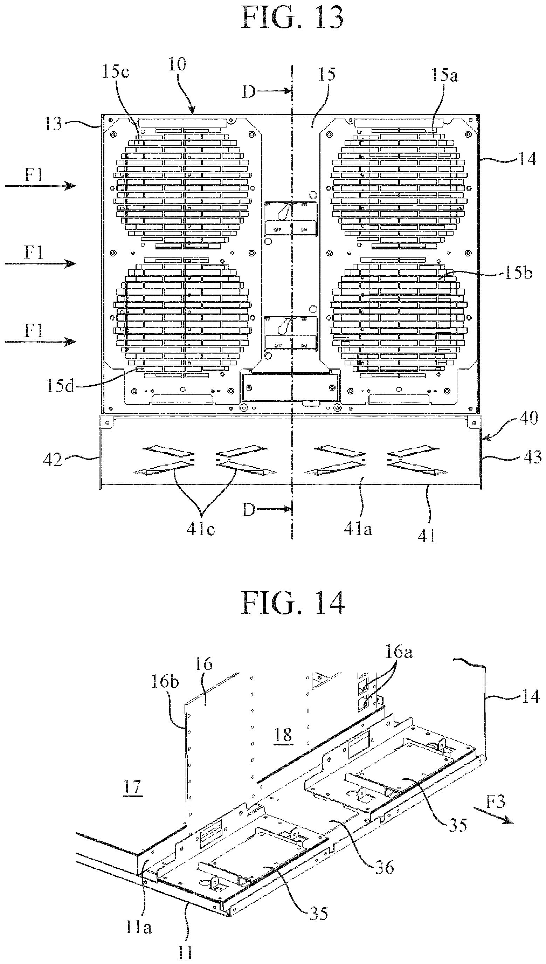

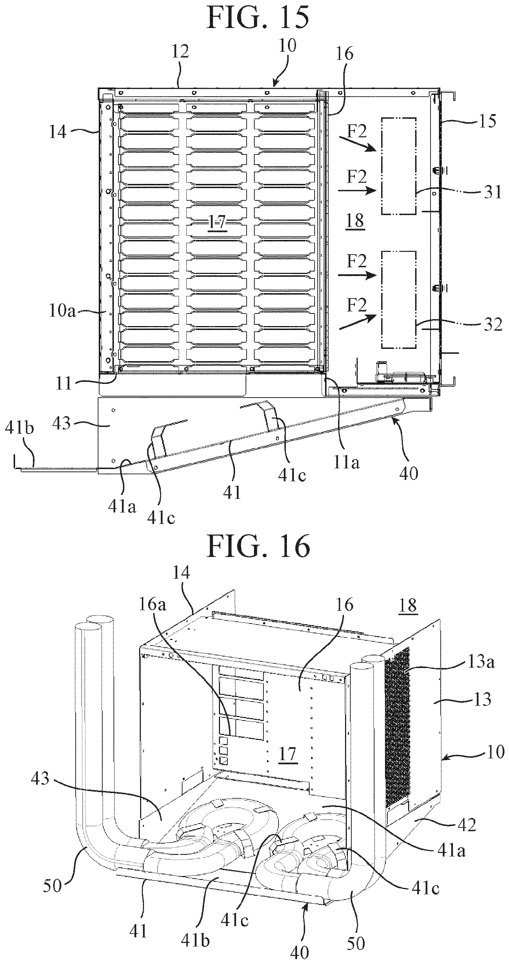

FIG. 9 is an overall perspective view of the electronic apparatus according to the second embodiment. FIG. 10 is a cross-sectional arrow view taken along line C-C in FIG. 9. FIG. 11 is a right side view of the electronic apparatus according to the second embodiment. FIG. 12 is a left side view of the electronic apparatus according to the second embodiment. FIG. 13 is a rear view of the electronic apparatus according to the second embodiment. FIG. 14 is a rear perspective view illustrating a lower structure of a fan accommodating portion 18. FIG. 15 is a cross-sectional arrow view taken along line D-D in FIG. 13. FIG. 16 is a diagram illustrating a wiring state by optical fibers 50. Note that FIG. 14 is a diagram in which cooling fans 31 to 34 are omitted. FIG. 15 is a diagram in which boards 20 are omitted. FIG. 16 is a diagram in which a bottom plate 11, a top plate 12, and the boards 20 are omitted.

The electronic apparatus according to the second embodiment has a structure in which a riser 11a of the bottom plate 11 and a wire tray 40 are added to the electronic apparatus according to the first embodiment. In the second embodiment, components having the same functions as those of components described in the first embodiment are denoted by the same reference numerals, and description thereof will be omitted.

As illustrated in FIGS. 14 and 15, the bottom plate 11 forms a bottom of a board accommodating portion 17 and a bottom of the fan accommodating portion 18.

The bottom plate 11 has the riser 11a. The riser 11a integrally connects the bottom of the board accommodating portion 17 and the bottom of the fan accommodating portion 18 and allows the height of the bottom of the fan accommodating portion 18 to be lower than the height of the bottom of the board accommodating portion 17. In a lower portion of the fan accommodating portion 18, boards 35 and 36 for controlling the cooling fans 31 to 34 are provided.

In this manner, the electronic apparatus includes the riser 11a on the bottom plate 11 and thereby allows the height of the bottom of the fan accommodating portion 18 to be lower than the height of the bottom of the board accommodating portion 17, thereby making it possible to provide an installation space for installation of the boards 35 and 36 in the lower portion of the fan accommodating portion 18. With this structure, in the electronic apparatus, installation of the boards 35 and 36 does not affect the flow of the cooling air F2 to be discharged from exhaust openings 15a to 15d since it is not necessary to install the boards 35 and 36 around the cooling fans 31 to 34. As a result, the electronic apparatus can improve the cooling performance for the boards 20.

Meanwhile, as illustrated in FIGS. 9 to 13, 15, and 16, the electronic apparatus includes the wire tray 40 under a housing 10. The wire tray 40 is attached to the bottom plate 11 of the housing 10 and accommodates cables connected to the housing 10 between the wire tray 40 and the bottom of the board accommodating portion 17. The wire tray 40 as the above is, for example, a metal tray accommodating the optical fibers 50 and has a bottom plate 41, a right side plate 42, and a left side plate 43.

The bottom plate 41 is provided for a bottom of the wire tray 40. The right side plate 42 is provided at a right side end of the bottom plate 41, and the left side plate 43 is provided at a left side end of the bottom plate 41. That is, the wire tray 40 has a structure in which the front and the top are open. In the wire tray 40, an upper end of the right side plate 42 and an upper end of the left side plate 43 are joined to a lower surface of the bottom plate 11 in the housing 10.

Further, the bottom plate 41 has an inclined portion 41a, a horizontal portion 41b, and holding portions 41c. The inclined portion 41a and the horizontal portion 41b form the top surface of the bottom plate 41. The inclined portion 41a is provided for a rear portion of the bottom plate 41. The inclined portion 41a is inclined downward gradually from a rear side to a front side of the wire tray 40. The horizontal portion 41b is provided horizontally for a front portion of the bottom plate 41. Furthermore, the horizontal portion 41b is located on the front side with respect to the right side plate 42 and the left side plate 43.

A holding portion 41c is formed in a hook shape and is provided on the inclined portion 41a. Moreover, the holding portions 41c are provided in such a way as to face the board accommodating portion 17 of the housing 10. Furthermore, for example, four holding portions 41c are set as one set, and one optical fiber 50 is accommodated in the wire tray 40 by using one set of holding portions 41c. In the example of FIG. 16, the wire tray 40 has two sets of holding portions 41c, and these two sets of holding portions 41c are used to accommodate two optical fibers 50.

Here, it is required that an optical fiber 50 be connected while keeping an allowable bend radius since the transmission loss increases as the bend radius is smaller. Holding portions 41c hold an optical fiber 50 in a state in which the optical fiber 50 is bent at its allowable bend radius. The optical fibers 50 held by the holding portions 41c are connected while placed on a top surface of the inclined portion 41a and a top surface of the horizontal portion 41b.

As a result, the electronic apparatus includes the wire tray 40 under the bottom plate 11 having the riser 11a, and thus it is possible to provide an accommodation space for accommodating the optical fibers 50 between the bottom of the board accommodating portion 17 and the bottom of the wire tray 40. With this structure, the electronic apparatus can maintain the cooling performance for the boards 20 since wiring by the optical fibers 50 does not obstruct the vicinity of the exit side of the intake opening 13a nor the vicinity of the entry side of each of the exhaust openings 15a to 15d.

As described above, in the electronic apparatus according to the second embodiment, the height of the bottom of the fan accommodating portion 18 is lower than the height of the bottom of the board accommodating portion 17. As a result, the electronic apparatus can provide the installation space for installation of the boards 35 and 36 in the lower portion of the fan accommodating portion 18. As a result, the electronic apparatus can improve the cooling performance for the boards 20 since installation of the boards 35 and 36 does not affect the flow of the cooling air F2 to be discharged from the exhaust openings 15a to 15d.

Meanwhile, in the electronic apparatus according to the second embodiment, the housing 10 has the bottom plate 11 forming the bottom of the board accommodating portion 17 and the bottom of the fan accommodating portion 18 and connecting the bottoms using the riser 11a, and the wire tray 40 which is attached to the bottom plate 11 and accommodates the optical fibers 50 between the board accommodating portion 17 and the wire tray 40 is included. As a result, the electronic apparatus can provide the accommodation space for accommodating the optical fibers 50 between the bottom of the board accommodating portion 17 and the bottom of the wire tray 40. As a result, the electronic apparatus can maintain the cooling performance for the boards 20 since wiring by the optical fibers 50 does not obstruct the vicinity of the exit side of the intake opening 13a nor the vicinity of the entry side of each of the exhaust openings 15a to 15d.

Note that the present invention may include a flexible combination of the embodiments, a modification of any component in the embodiments, or an omission of any component in the embodiments within the scope of the present invention.

### INDUSTRIAL APPLICABILITY

An electronic apparatus according to the present invention includes an intake opening in a side plate of a housing accommodating a board, thus is capable of cooling a heat-generating component mounted on the board without including an intake opening in a bottom portion of the housing, and is suitable for use as an electronic apparatus and the like including a cooling structure that cools a board.

### REFERENCE SIGNS LIST

10: housing, 10a: front opening, 11: bottom plate, 11a: riser, 12: top plate, 13: right side plate, 13a: intake opening, 14: left side plate, 15: rear plate, 15a to 15d: exhaust opening, 16: backboard, 16a: left side vent, 16b: right side vent, 17: board accommodating portion, 18: fan accommodating portion, 20: board, 31 to 34: cooling fan, 35, 36: board, 40: wire tray, 41: bottom plate, 41a: inclined portion, 41b: horizontal portion, 41c: holding portion, 42: right side plate, 43: left side plate, 50: optical fiber

## Claims

1. An electronic apparatus comprising:
a board accommodating portion that accommodates a board in a horizontally placed state, the board accommodating portion provided inside a housing;
an intake opening provided in one of a plurality of side plates of the housing and communicating with the board accommodating portion;
an exhaust opening provided in a rear plate of the housing;
a cooling fan provided in such a way as to face the exhaust opening; and
a backboard that is a partition between the board accommodating portion and a fan accommodating portion that accommodates the cooling fan,
wherein a left side portion and a right side portion of the backboard each have a vent through which the board accommodating portion and the fan accommodating portion communicate with each other.

2. The electronic apparatus according to claim 1,
wherein a height of a bottom of the fan accommodating portion is lower than a height of a bottom of the board accommodating portion.

3. The electronic apparatus according to claim 2,
wherein the housing has a bottom plate that forms the bottom of the board accommodating portion and the bottom of the fan accommodating portion, and that connects the bottoms using a riser, and
included is a wire tray to accommodate a cable between the board accommodating portion and the wire tray, the wire tray attached to the bottom plate.
